(19) **Europäisches Patentamt**
**European Patent Office**
**Office européen des brevets**

(11) **EP 4 716 416 A1**

(12) **EUROPEAN PATENT APPLICATION**

(43) Date of publication:
**25.03.2026 Bulletin 2026/13**

(21) Application number: **25203355.0**

(22) Date of filing: **19.09.2025**

(51) International Patent Classification (IPC):
*H10F 10/161* (2025.01)     *H10F 10/167* (2025.01)

(52) Cooperative Patent Classification (CPC):
**H10F 10/167; H10F 10/161**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **20.09.2024 US 202463697232 P**

(71) Applicant: **Zentrum für Sonnenenergie-und
Wasserstoffforschung
Baden-Württemberg (ZSW)
70563 Stuttgart (DE)**

(72) Inventors:
• **KANEVCE, Ana
70563 Stuttgart (DE)**
• **BAGROWSKI, Dominik
70563 Stuttgart (DE)**

(74) Representative: **Lorenz Seidler Gossel Part. mbB
Widenmayerstr. 23
80538 München (DE)**

(54) **A TANDEM SOLAR CELL**

(57)     A tandem solar module having a top and bottom cell. The bottom cell has been optimized to account for the wavelength spectrum/photons that are absorbed/filtered by the top cell where such absorbed/filtered photons could impact the operation of the bottom cell with respect to efficiently collecting the non-absorbed/filtered photons in the bottom cell.

EP 4 716 416 A1

**Description**

The never-ending quest for increased efficiency in solar cells has continued to push the current technology limits for a single junction solar cell. As such, the industry will need to use a multi-junction solar cell capable of capturing a wider range of the light spectrum to keep the quest alive. A tandem solar module is one approach to creating a multi-junction solar cell by combining two separate solar cells (top cell and bottom cell) together to capture a greater range of the light spectrum.

This combination often of differing technologies presents unique challenges which the present invention addresses.

The present invention is a tandem solar module having a top and bottom cell. The bottom cell has been optimized to account for the wavelength spectrum/photons that are absorbed/filtered by the top cell where such absorbed/filtered photons could impact the operation of the bottom cell with respect to efficiently collecting the non-absorbed/filtered photons in the bottom cell.

The present invention relates to a photovoltaic device according to claim 1, to a photovoltaic device according to claim 6 and to a photovoltaic filter according to claim 9.

Preferred embodiments of the invention are the subject-matter of the sub-claims.

Figure 1 is a cross-sectional view illustrating a tandem solar module 1000 having a top cell 1010 and a bottom cell 1020 according to the teachings of the present invention;

Figures 2A-E are simulated plot diagrams illustrating current-density-voltage curves to determine the maximum efficiency using the maximum achievable solar cell parameters as defined by the Shockley Queisser (SQ) analysis for AM 1.5 spectrum illumination of a Test Cell in the relevant bandgap region of 1-1.15eV according to the teachings of the present invention;

Figure 3A is a plot diagram illustrating the JV measurements for both an unfiltered (i.e., a non-tandem configuration) and filtered illumination of Test Cell/bottom cell 1020 according to the teachings of the present invention;

Figure 3B is a box plot diagram illustrating the time behavior of the FF of a non-tandem/filtered typical CIGS cell;

Figure 4 is an equilibrium band diagram simulated for a typical CIGS cell/TC of Figure 1 according to the teachings of the present invention;

Figure 5A is a calculated/simulated JV plot curves for ideal, white light exposed, and Filtered (Targeted Spectrum) TC cells according to the teachings of the present invention;

Figure 5B is a plot diagram of JV curves for the TC/bottom 1020 cells of Figure 1 for various temperatures (150K, 225K, and 295K) and white, filtered, and dark light spectrum illumination according to the teachings of the present invention;

Figures 6A-B are contour plots of simulated FF and efficiency of the TC/Bottom cell 1020 of Figure 1 under the Target Spectrum as a function of carrier density (factor of 2, $1 \times 10^{17} cm^{-3}$ and $2 \times 10^{17} cm^{-3}$) in Buffer 1 (CdS) and a carrier density (three orders $0.01 \times 10^{17} cm^{-3}$, $0.1 \times 10^{17} cm^{-3}$, and $10 \times 10^{17} cm^{-3}$) Buffer 2 (ZMO) according to the teachings of the present invention;

Figure 7A is a measured IV curve for Buffer 2 (ZMO) of Figure 1 having thicknesses of 0 nm (702), 10nm (704), 35nm (706), and 50 nm (708) illuminated under the white light spectrum according to the teachings of the present invention

Figure 7B is a measured fill factor diagram for Buffer 2 (ZMO) of Figure 1 having thicknesses between 0-50 nm unfiltered 710, 700 nm light soak and white light soak 714 according to the teachings of the present inventio;

Figure 7C is a simulated equilibrium band diagram for Buffer 2(ZMO) of Figure 1 having thicknesses of 10 nm (750), 50 nm (752), and 50 nm (754) highly doped according to the teachings of the present invention;

Figure 8 is a box-plot diagram illustrating a comparison of the typical FF with 700-nm filtered illumination behavior before and after optimization for three different CIGS cells according to the teachings of the present invention; and

Figure 9 is a diagram illustrating a two-layer Buffer 2 (ZMO) layer according to the teachings of the present invention.

The never-ending quest for increased efficiency in solar cells has continued to push the current technology limits for a single junction solar cell. As such, the industry will need to use a multi-junction solar cell capable of capturing a wider range of the light spectrum to keep the quest alive. A tandem solar module is one approach to creating a multi-junction solar cell by combining two separate solar cells (top cell and bottom cell) together to capture a greater range of the light spectrum. The type of solar cell technology is often identified by the type of material used as the absorber. The absorber is responsible for absorbing photons of a specific portion of the light spectrum (wavelength) and generating pairs of electrons and holes (electron/hole) to be collected for the generation of electricity.

The high-level concept of combining these differing light spectrum cells seems conceptually simple. However, as often is the case, reality is drastically different. Specifically, when using these types of differing light spectrum technologies, the underlying optimizations and technology assumptions that were used in the design of the bottom cell, which were based on its prior non-tandem (**i.e.**, solely) activity, can create unique issues. These issues, unless identified, understood and accounted for can result in a tandem solar module with deficiencies that can result, for example, in decreased efficiency.

More specifically, when combining two differing light spectrum technologies (e.g., Perovskites and CIGS) it is important but easy to overlook how the prior non-tandem operation of the bottom cell design could be impacted by the limited/filtered light spectrum from the operation of the top cell technology. It would be advantageous if the bottom cell design would account for the limited/filtered light spectrum of the top cell to avoid deficiencies that could diminish the operation of the bottom cell.

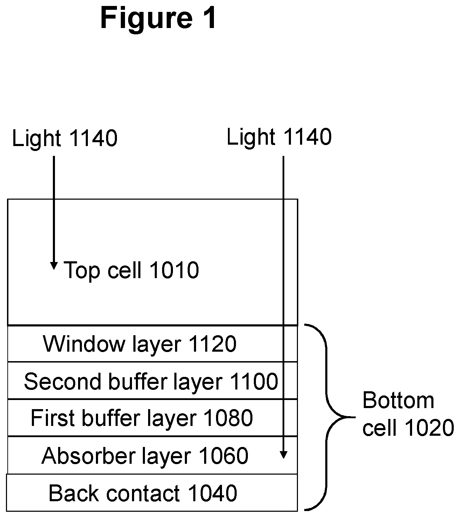

Reference now being made to Figure **1,** a cross-sectional view of a tandem solar module **1000** is illustrated according to the teachings of the present invention. The tandem solar module **1000** includes a top cell **1010** and a bottom cell **1020** each optimized to capture specific portions of the light spectrum. The specific technology (**e.g.,** c-Si, Perovskites, CdTe, etc...) that is used for the top cell **1010** is not intended to be a limitation on the teachings of the present invention, but rather one or more technology specific embodiments are presented below as particular examples to assist with the teachings of the present invention.

The type of solar cell technology is often identified by the type of material used as the absorber. The absorber is responsible for absorbing photons of a specific portion of the light spectrum (wavelength) and generating pairs of electrons and holes (electrons/holes) to be collected for the generation of electricity. In the embodiments of the present invention, the bottom cell **1020** is illustrated as a representation of the thin film technology known as Copper, Indium, Gallium, Selenide (CIGS or CIS) via absorber **1060**. The CIGS technology is ideal for bottom cell tandem applications because of its low material usage, low energy costs, light weight and flexibility, and Conduction Band Gap (CBG) tunability between 1 to 1.7 electron volts (eV) which is ideal for a bottom cell tandem configuration. The range of 1 to 1.15 eV is suitable for a top cell 1010 of CdTe or Perovskite technology.

Interfacial layers such as window **1120,** second buffer **1100,** first buffer **1080,** and back contact **1040** interact with the absorber **1060** to assist with the photovoltaic effect and collection of the emitted electron/hole pairs. The window layer **1120** should allow sufficient transmission of the desired wavelength while also being conductive to assist with the collection of the emitted electron/hole pairs. The first and second buffer layers (Buffer 1-2) **1080** and **1100** should also allow the desired wavelength to reach the absorber 1060 while creating the necessary interface properties to collect the emitted electron/hole pairs. The back contact **1040** should sufficiently assist with the collection of the electron/hole pairs. In one embodiment, the back contact **1040** includes the desired characteristics of reflecting light back into the device from the front side while allowing light to enter from the back side (bi-facial). In another embodiment, the back contact **1040** includes the desired characteristics of reflecting light back into the device from the front side without bifacial characteristics.

In a preferred embodiment of the present invention, the materials of the top cell **1010** will absorb and thus filter/prevent most wavelengths below 700 nm while allowing most wavelengths above or equal to 700 nm to pass to the bottom cell 1020 (**i.e.,** a 700nm long pass filter, referred to hereinafter as the Targeted Spectrum). One such technology for the top cell **1010** having these characteristics would be perovskites.

## Test Cell and Test Equipment Parameters

The first step in determining how the filtering of the < 700 nm light spectrum by the top cell **1010** effects the bottom cell **1020** efficiency is to determine/verify the theoretical maximum bottom cell **1020** efficiency under these conditions. This is accomplished with simulations using the following bottom cell **1020** materials, thickness, and process parameters in conjunction with reference to Figure **1** (hereinafter referred to as Test Cell (TC)).

| CIGS layer | Thickness | process |
|---|---|---|
| Absorber (**1060**) | 2-2.4 μm | Grown by co-evaporation with Ga/(Ga+In) (GGI) ratio from 0 to 0.3 and completed with an in-situ RbF post deposition treatment (PDT) |
| Buffer 1 (**1080**) | 30-50 nm | CdS layer grown by a chemical bath deposition (CBD) |

(continued)

| CIGS layer | Thickness | process |
|---|---|---|
| Buffer 2 (**1100**) | 0-100 nm | ZnMgO layer with 15mol% MgO deposited by radio-frequency (RF) magnetron sputtering |
| Window(**1120**) | 190 nm | Al:ZnO layer deposited by pulsed direct current (DC) magnetron sputtering. |
| Back Contact (**1040**) | X | X |

The Current-density-voltage JV-curves illustrated in the figures, unless otherwise specifically stated otherwise, are generated using a WACOM Super Solar Simulator WXS- 90S-L2 (grade AAA) under one sun AM1.5G (A110) at 24°C calibrated with a Si reference cell. Note, before these measurements, the TCs were kept in the dark for 24 hours and carefully shielded from light until the measurement.

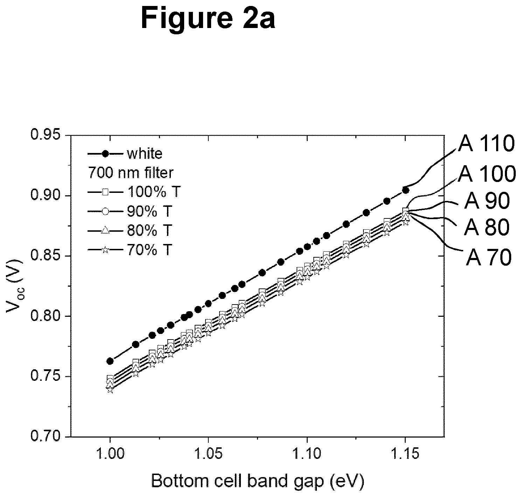

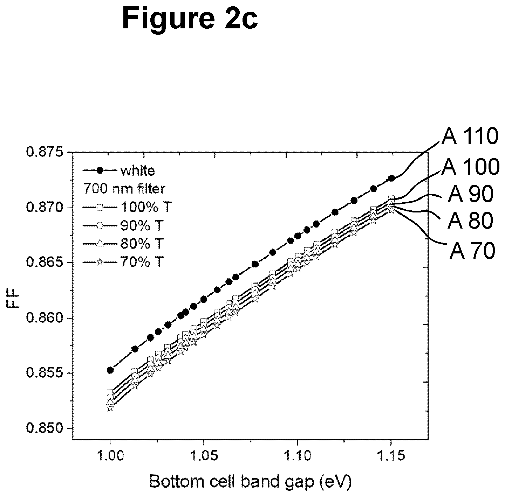

Figures **2A-E** are simulated plot diagrams illustrating current-density-voltage curves to determine the maximum efficiency using the maximum achievable solar cell parameters as defined by the Shockley Queisser (SQ) analysis for AM 1.5 spectrum illumination of the TC in the relevant bandgap region of 1-1.15eV according to the teachings of the present invention. The filtered JV-curves were simulated with a 700-nm long pass filter with 100%, 90%, 80% and 70% transmission for wavelengths above 700 nm.

The following symbols in the diagrams are used to illustrate the indicated percentage of the Targeted Spectrum (>=700nm) reaching the TC with the indicated designator for the plots representing these percentages in Figures **2A-E:**

| Symbol | Percentage | Plot indicated designator |
|---|---|---|
| Solid Square | 100 | A 100 |
| Circle | 90 | A 90 |
| Triangle | 80 | A 80 |
| Star | 70 | A 70 |

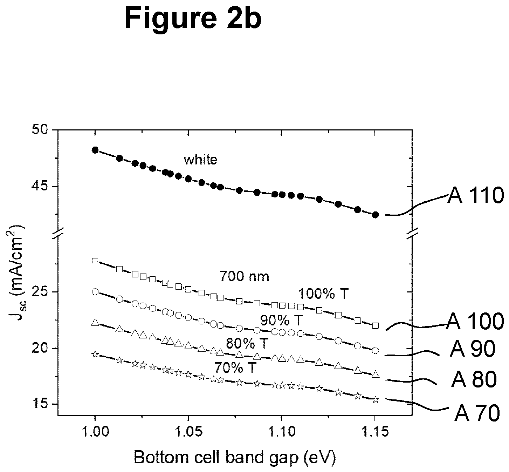

As noted in Figure **2B,** the filtered TC photocurrent (Joc) increases with TC 1020 bandgap reduction, but the increase is not linear due to the non-linearity of the AM 1.5 spectrum. As illustrated in Figure **2A,** the maximum achievable $V_{OC}$ decreases linearly with a decreased bandgap. Overall, the targeted wavelength shows $V_{OC}$ vs. bandgap curves being shifted downwards, due to the decreased quasi-Fermi level splitting at lower illumination intensities. The Fill Factor is dependent on the $V_{OC}$, and therefore on the bandgap of the TC and can be expressed as:

$$FF = \frac{(v_{oc} - \ln(v_{oc} + 0.72))}{v_{oc} + 1},$$

wherein $v_{oc}$ is a characteristic voltage $v_{oc} = V_{OC}/AkT$, which includes a dependence on diode quality factor and temperature. As a result, an inherent decrease of FF with bandgap is expected. A bandgap decrease from 1.15 eV to 1.00 eV corresponds to a FF reduction of 1.5% absolute.

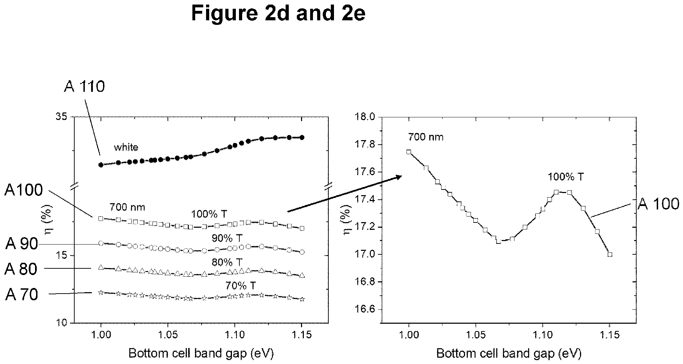

As shown in Figure **2E,** the SQ efficiency of the TC increases with a bandgap decrease from 1.15eV to 1.1eV, then starts decreasing for bandgaps from 1.1eV to 1.05 eV, after it starts increasing again for bandgap decrease below 1.05 eV to 1.00 eV. This translates into the recognition that there is no efficiency benefit for a bandgap reduction of the TC from 1.1 eV to 1.03 eV in a 4 Terminal (4T) tandem device configuration having a top cell 1010 with a bandgap of 1.77 eV (corresponding to filtering 700 nm).

Partial absorption of the Targeted Spectrum photons (>=700nm) in the top cell 1010 decreases the $J_{SC}$ and slightly shifts the $V_{OC}$ and FF curves downwards for the TC. As such, the efficiency losses due to incomplete top cell 1010 transmission of the Targeted Spectrum are rather high for the TC. For example, as shown in Figures **2D-E**, a 10% top cell transmission reduction decreases the maximum TC bottom cell efficiency by 1.77% absolute. This emphasizes the importance of the top cell transmission of the Targeted Spectrum for the bottom cell **1020** and suggests that optimizing the optics of the top cell to increase the transmission of the Targeted Spectrum.

## Red Kink Effects in TC

A well-known phenomenon of CIGS solar cells is the presence of an S-shaped current-density voltage (JV) curve in the absence of blue photons (**i.e.,** Targeted Spectrum), often referred to as 'red kink'.

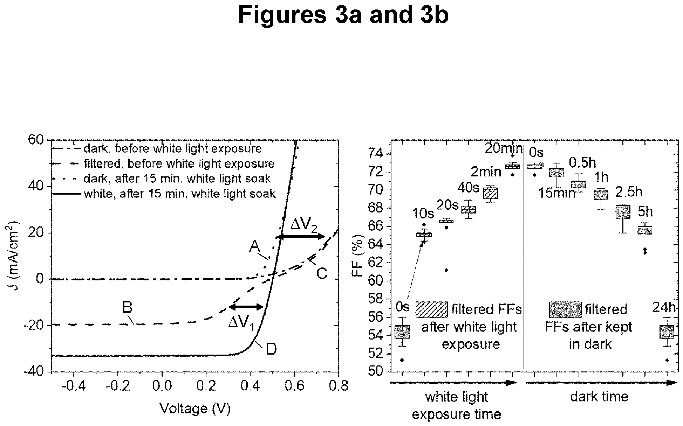

Reference now being made to Figure 3A, a plot diagram of the JV measurements of the TC are illustrated for both an unfiltered (i.e., a non-tandem configuration) and filtered/TC bottom cell 1020 illumination according to the teachings of the present invention. The filtered JV curve (B) has a higher turn-up voltage in comparison with JV curve illuminated with the entire spectrum (D), referred to as a crossover ($\Delta V_2$). The dark JV curve before the cell was exposed to white illumination (C) follows the filtered curve for $V > V_{OC}$, while the dark curve after blue photons exposure follows the white curve (A). As noted, the filtered JV curve (B) has an S-shape and a significantly lower FF in comparison to the non-filtered JV curve. It should be noted that in a non-tandem CIGS cell that is exposed to the full light spectrum (i.e., non-tandem operation) there is a FF recovery and decrease of light/dark crossover within seconds of white-light (Full spectrum) exposure.

Reference now being made to Figure 3B, a box plot diagram is shown illustrating the time behavior of the FF of a non-tandem/filtered typical CIGS cell. After 24 hours in the dark (at time = 0s), the samples had FFs averaging 55%. After only 10 seconds of white-light exposure, the FF of the exposed TC samples increased by approximately 10%. Additional time being exposed to the white-light resulted in an additional increase, and after 20 minutes of white light soak the exposed samples achieved FFs > 70%. As illustrated, CIGS cell in a non-tandem configuration mitigates this phenomenon with a brief white light soak (**i.e.,** exposure to blue light). In the case of a tandem configuration where CIGS technology is used for the bottom cell it will not receive this light soak effect and a different mechanism will need to be used to address the red kink.

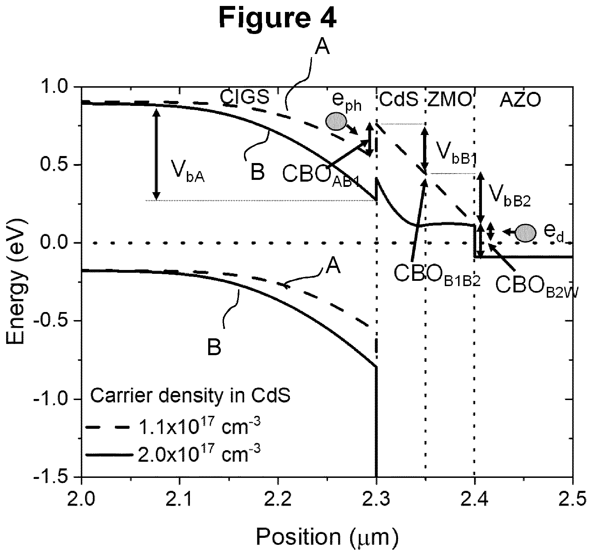

Reference now being made to Figure **4,** a simulated equilibrium band diagram for a typical CIGS cell (**e.g.,** FIG. **1**) is illustrated according to the teachings of the present invention. Lines represented with the A designation correspond to energy bands when the carrier density in CdS is low (e.g., $1.1 \times 10^{17}$ cm$^{-3}$), mimicking a situation without absorption of blue photons (**e.g.,** TC/bottom cell **1020**). In this case, significant/high band bending appears in the CdS ($Vb_{B1}$) and ZMO ($Vb_{B2}$) while it is low for the absorber (CIGS) ($V_{bA}$). It should also be noted that the Fermi level at the interface and in the space-charge region is close to the middle of the bandgap, thus encouraging Shockley-Read-Hall (SRH) recombination which is undesirable.

With continuing reference to Figure **4,** after white-light exposure (lines represented with the B designation), the absorption in the buffer layers (CdS and ZMO) increases their free carrier density (with CdS being $2.0 \times 10^{17}$ cm$^{-3}$), shifting the conduction band down towards the Fermi level, and decreasing the band bending in the buffers (Buffer 1-2). The band bending in this case is almost exclusively in the absorber layer ($V_{bA} > V_{bB1} + V_{bB2}$), and the CIGS interface is inverted. The Fermi level at the CIGS/CdS interface is away from the mid-band-gap region, thus discouraging interface recombination which is desirable. The barriers for the electrons in the photocurrent direction as well as in forward direction are lower, decreasing $\Delta V_1$ and $\Delta V_2$ (Figure **3A**).

In addition to the band alignments between the neighboring layers (CIGS/CdS/ZMO/AZO), which are dependent on the material choice and independent from measurement conditions, the CIGS cell performance is dependent on the electrical properties of each layer as well. The vertical arrow designations including a brief description of their representation are provided below to assist in pointing out features influencing non-ideal JV behavior in the absence of high-energy photons (TC/bottom cell 1020 in the Targeted Spectrum) as compared to presence of such high-energy photons:

- band bending in the absorber layer ($Vb_A$) influenced by the buffer, window and absorber properties;
- conduction-band offset ($CBO_{AB1}$) between the absorber and CdS buffer;
- band bending in the CdS layer ($Vb_{B1}$), influenced by its thickness, carrier density and defect properties, conduction band offset between CdS and ZMO ($CBO_{B1B2}$), band bending in the ZMO layer ($Vb_{B2}$), influenced by its thickness, carrier density and defect properties, and
- band alignment between ZMO and Al:ZnO layer defined by the Mg content in ZMO ($CBO_{B2W}$). The barrier the electrons see in the diode direction at this interface is determined by the distance between the Fermi level in AZO and the conduction-band minimum in ZMO.

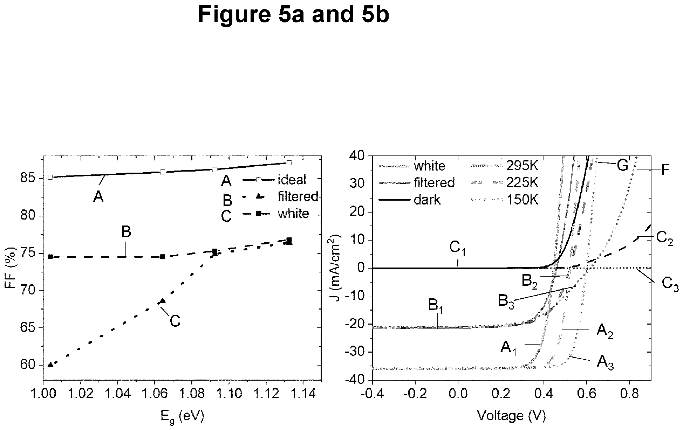

The impact of these parameters on filtered cell performance (i.e., TC/bottom cell 1020 in the Targeted Spectrum) are discussed below in connection with Figures **5A-B**.

An incorrect, but frequently discussed, assumption is that the band gap offset between the CIGS absorber and the CdS layer (Buffer 1) is the reason for the secondary barrier and the consequent FF loss in an absence of blue photons for the TC/bottom cell **1020** in the Targeted Spectrum. Following this assumption, decreasing the absorber bandgap of the TC/bottom cell **1020** as much as possible would be considered advantageous for taking full advantage of the solar spectrum and maximizing the photocurrent. As previously mentioned, the conduction band minimum of the absorber is lowered by decreasing the Ga content which decreases the bandgap predominantly.

With continuing reference to Figure **4,** the downshift of the conduction-band minimum increases the CBO between the absorber and the buffer layer ($CBO_{AB1}$), and accordingly the barrier for the photo-generated electrons ($e_{ph}$) traveling from the CIGS absorber towards the Buffers 1-2 (CdS/ZMO) and Window (AZO). A higher positive conduction-band can create a secondary barrier and reduce the FF as explained below in connection with Figures **5A-B**.

Reference now being made to Figure **5A,** calculated/simulated JV plot curves are illustrated for ideal, white light exposed, and Filtered (Targeted Spectrum) TC cells according to the teachings of the present invention. The calculated ideal FF when $V_{OC}$ has a value determined by SQ theory is shown by line A. The measured FFs as a function of absorber bandgap for the unfiltered CIGS cells (white light) are shown with by line B, and those of the filtered (Targeted Spectrum) TC/bottom cells 1020 by line C. The FF of the unfiltered (lines B and A) TC cell is consistent with expectations. The FFs of the filtered TC cells before white light exposure match the full-spectrum FFs for the higher bandgap samples, but show an additional decrease for bandgaps below 1.09 eV (Line C), indicating an additional loss mechanism. This is an indication that the conduction band offset between the TC Absorber and Buffer 1 (CdS) ($CBO_{AB1}$, Figure **4**) is not the main or sole cause of the red kink behavior. A Temperature-activated process is investigated as the next potential influencer on the red kink behavior in connection with the description of Figure **5B.**

Reference now being made to Figure **5B,** a plot diagram of JV curves for TC/bottom 1020 cells for various temperatures (150K, 225K, and 295K) and white, filtered, and dark light spectrum illumination is illustrated according to the teachings of the present invention. These JV curves A1-3, B1-3, and C1-3 provide insights into the TC/Bottom 1020 barrier properties. The unfiltered JV curves are measured first (lines A1, B1, and C1), and the filtered curves (lines A2, B2, and C2) with Targeted Spectrum directly afterwards (**note,** all the cells were exposed to white light before the measurement).

Although the room temperature JV curves (lines A1, B1, and C1) do not show an S shape, the FF of the filtered (Targeted Spectrum) TC/Bottom 1020 cell (C) is 64%, while the FF of the nonfiltered TC/Bottom 1020 cell (B) is 72%. If the main transport over secondary barriers is thermionic emission, the impact of the barriers should be observed more strongly at lower temperatures. While the white-light/ non-filtered illuminated curves remain well behaved and show a $V_{OC}$ increase by lower temperature (A2-3), the filtered curves show an increased FF loss and higher apparent series resistance (B2-3). It is interesting to note that the dark curves showed a stronger blocking behavior in the forward direction compared to the filtered curves (C1-3). These curves indicate a mechanism that is sensitive to filtered light/Targeted Spectrum.

### Buffer layer current carrier density and thickness

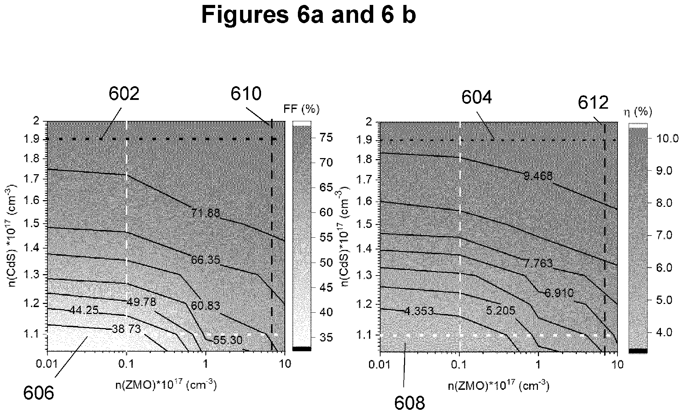

In addition to the band offset between the Absorber and the Buffer 1 layer (CdS), the band offsets between Buffer 1 (CdS) and Buffer 2 (ZMO) ($CBO_{B1B2}$) as well as the CBO between Buffer 2 (ZMO) and Window (AZO) ($CBO_{B2W}$) layer have a significant impact on TC/Bottom 1020 cell performance. The $CBO_{B1B2}$ and $CBO_{B2W}$ are affected by a variation of Mg content in Buffer 2 (ZMO). In the embodiments of the present invention described below, the Mg amount in Buffer 2 (ZMO) is maintained as constant $\frac{Mg}{(Mg+Zn)} = 0.15$, in order to assist with focusing on the carrier density and thickness of the Buffer (1-2) layers in connection with Figures **6A-B** below.

Reference now being made to Figures **6A-B**, contour plots of simulated FF and efficiency of the TC/Bottom 1020 under the Target Spectrum as a function of carrier density (factor of 2, $1x10^{17}cm^{-3}$ and $2x10^{17}cm^{-3}$) in Buffer 1 (CdS) and a carrier density (three orders $0.01x10^{17}cm^{-3}$, $0.1x10^{17}cm^{-3}$, and $10x10^{17}cm^{-3}$) Buffer 2 (ZMO) are illustrated according to the teachings of the present invention. Note, the plots assume the defect density in Buffer 1 (CdS) to be $1x10^{17}cm^{-3}$ resulting in the ratio between the doping and the defect density increasing significantly. These contour plots show that the FF is significantly more sensitive to the Buffer 1 (CdS) properties, as this layer is prone to a stronger band bending due to the lower carrier density in the Absorber (CIGS) as compared to Window (AZO) and can create a more effective barrier for the photo-generated carriers.

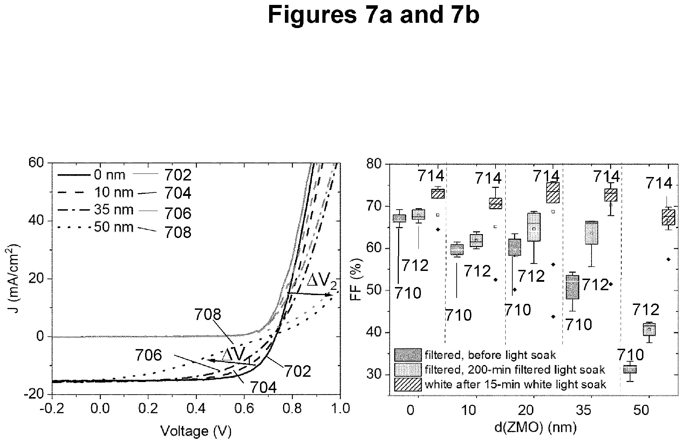

For example, for a carrier density of $1.9x10^{17}cm^{-3}$ in Buffer 1 (CdS), the FF of the filtered JV curve remains over 70%, even if Buffer 2 (ZMO) carrier density is decreased for 2 orders of magnitude (602 Figure **6A**), and the efficiency of the filtered/Targeted Spectrum TC/Bottom 1020 cell remains between 9 and 10% (604 Figure **6B**). For a CdS carrier density of $1.10x10^{17}cm^{-3}$, the carrier density in ZMO can make a difference between a FF of 35 and 65% (606 Figure **6A**), resulting in a filtered cell efficiency raising from below 4% to ~8% (608 Figure 6B). For a carrier density of $10^{17}cm^{-3}$ in the ZMO, doubling the carrier density in the CdS can change the FF from 35% to 75% (610 Figure **6A**), resulting in a filtered cell efficiency from below 4% to ~10% (612 Figure 6B). A highly doped ZMO layer decreases this sensitivity, and even for low carrier density in CdS, the FF stays in the 50% and above range (610 and 612). Increasing the ZMO doping will decrease the sensitivity of performance to the CdS carrier density. The effect of the thickness of the ZMO is discussed in connection with Figures **7A-C**.

Reference now being made to Figures **7A,** a measured IV curve for Buffer 2 (ZMO) having thicknesses of 0 nm (702), 10nm (704), 35nm (706), and 50 nm (708) illuminated under the white light spectrum is illustrated according to the teachings of the present invention. As illustrated, the thinning of Buffer 2 (ZMO) decreases the effect of band bending.

Reference now being made to Figure **7B,** a measured fill factor for Buffer 2 (ZMO) having thicknesses between 0-50 nm unfiltered 710, 700 nm light soak 712, and white light soak 714, is illustrated according to the teachings of the present invention. As illustrated, the thinning of Buffer 2 decreases the effect of band bending.

Thinning the ZMO (or either of the buffers for that matter) decreases the band bending in the Buffers 1-2 as well as the barrier for carriers. However, Buffers 1-2 that are too thin can cause problems in CIGS cells. For example, incomplete coverage of the Absorber which is relevant with regard to sputter damage of the Absorber/Buffer interface and increased probability of shunts.

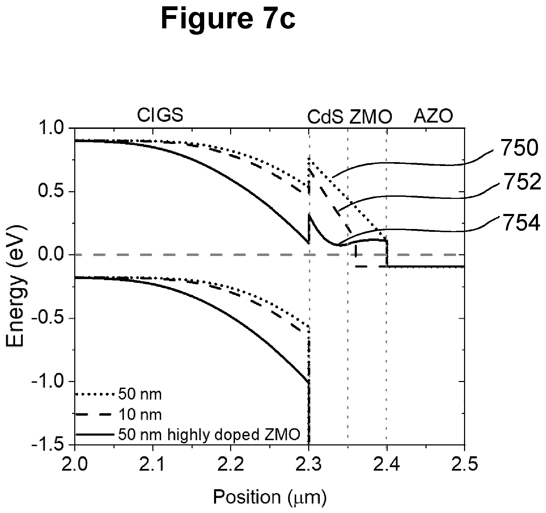

Reference now being made to Figure **7C,** a simulated equilibrium band diagram for Buffer 2(ZMO) having thicknesses of 10 nm (750), 50 nm (752), and 50 nm (754) highly doped is illustrated according to the teachings of the present invention. When comparing these alternatives (thinning vs. doping) of the Buffer 2 (ZMO layer), the doping has a greater effect and reduces the ZMO thickness dependence and concerns with thinning.

## Process for doping Buffer 2 (ZMO)

In the following description terms like "on" and "over" have the following meanings:

- **"On":** means that one layer is directly on top of another, with no intervening layers.

- **"Over":** means that one layer or component is above another, but not necessarily in direct contact. There could be one or more intervening layers between the two layers.

In a preferred embodiment of the present invention, oxygen-vacancies are used to dope Buffer 2 (ZMO), reducing oxygen content during the layer deposition generates more oxygen vacancies, resulting in higher doping. It is also important to protect the Buffer 1 (CdS) and absorber (CIGS) surface region from oxygen, especially O radicals. The preferred embodiment accomplishes this by creating a two-layer Buffer 2 (ZMO) where the first layer serves as the protective layer for the Buffer 1 (CdS) and Absorber (CIGS) surface region from O radicals and the second layer serves as the doping layer.

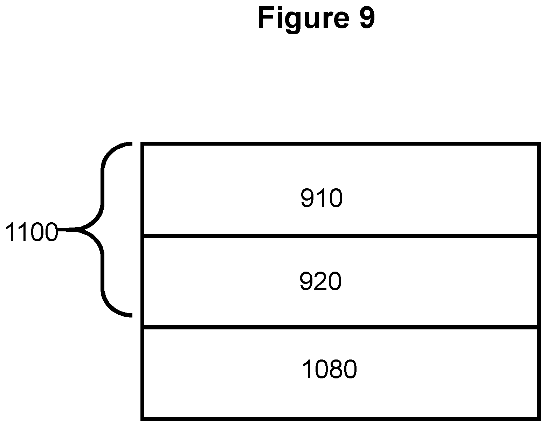

Reference now being made to Figure 9, the bottom cell 1020 of Figure 1 is illustrated as having a two-layer Buffer 2 (ZMO) layer according to the teachings of the present invention. In a preferred embodiment of the present invention, the CIGS photovoltaic cell/bottom cell 1020 is formed on a substrate with the Absorber 1090 being formed first, then Buffer 1 (CdS), and then Buffer 2 (ZMO). The particular order in which the CIGS photovoltaic device is constructed (e.g., absorber first vs. Buffer 2) is not to be considered as a limitation on the teachings of the present invention but rather as a convenient and efficient manner in which to create the CIGS photovoltaic device. The formation and doping of Buffer 2 1100 (ZMO), in one preferred embodiment a 70 nm thickness is desired, is accomplished by sputtering a ZMO from a single target in two stages to form two layers 910 and 920. It should be noted that more or less stages and/or layers could be used without departing from the scope and spirit of the teachings of the present invention:

- a first protective barrier formation stage to form approximately 50% (30% for the 70nm embodiment) is sputtered in an inert gas, such as pure argon gas, environment without oxygen and, for example, at a power density of 1 W/cm2 (First ZMO layer). The low power density is intended to assist with minimizing mechanical damage. This first ZMO layer 920 forms a protective barrier for the Buffer 1 1080 (CdS) and Absorber 1060 (CIGS) surface region to minimize reactive O radicals from the reactive layer formation stage from sufficiently reaching this region; and
- a second reactive layer 910 formation stage that occurs while an oxygen fraction of 0.3 vol% is introduced into the argon sputtering gas for the rest of the remaining thickness such as 70 nm layer (Second ZMO layer) and at, for example, a power density of 2 W/cm2. In this embodiment, the reduced oxygen generates more oxygen vacancies resulting in higher doping.

The substrate was maintained at approximately 100°C for both above noted stages.

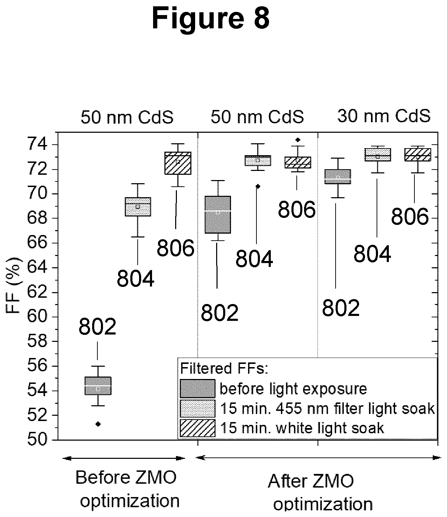

Reference now being made to Figure **8,** a box-plot diagram is shown illustrating a comparison of the typical FF with 700-nm filtered illumination behavior before and after optimization for three different CIGS cells according to the teachings of the present invention. Section a demonstrates the behavior of a CIGS cell representing the standard situation prior to optimization. Sections b and c show the behavior of CIGS cells with optimized ZMO (**i.e.,** heavily doped). In Sections a and b the Buffer 1 1080 (CdS) is 50-nm thick, and in Section c the CdS is 30 nm thick. For a clear analysis of device behavior, the cells were stored in the dark for 24 hours prior to measurement. Several measurement types are shown. The boxes with designations 802 represent filtered measurements under a 700nm filter with no other exposure to light. This situation is most relevant for bottom-cell behavior. The boxes with designations 804 show measurements under a 700-nm filter after light soaking under a 455-nm filter. The 455-nm filter was chosen to distinguish between effects of photon absorption in Buffer 2 1100 (ZMO) and in Buffer 1 1080 (CdS), as will be discussed in more detail below. The boxes with designations 806 represent the data acquired under a 700-nm filter, but after white-light illumination.

From Figure **8,** it is confirmed that the ZMO optimization (two layer ZMO/Buffer 2 110) creates the desired effect on bottom-cell performance. As indicated by the 802 box in Section a), non-optimized cells without white light exposure performed poorly, with FF in the low 50% range and S-shaped JV curves as previously discussed, while the optimized ZMO Sections c and d lead to FFs near or above 70%. Section c demonstrates additional gain by combining optimized ZMO with a reduced CdS film thickness.

The 802 box plots in Fig. **8** represent data acquired under a 700-nm filter after a light soak with a 455-nm long pass filter. The wavelength of 455 nm corresponds to an energy that is higher than that of Buffer 1 1080 (CdS) and lower than that of Buffer 2 1100 (ZMO), for example 2.7 eV, which is higher than the bandgap of CdS (2.4 eV), but lower than the bandgap energy of ZMO (3.8 eV for 15mol% Mg). Thus, the illumination with a 455-nm filter generates carriers in the CdS, but not in ZMO. These results are compared with those acquired under a 700-nm filter after a 15 min white-light soak after a 24- hours period of dark storage, shown in boxes 806. The cells before the ZMO optimization/two layer (Section a) showed a FF improvement from ~50% to 65% after a 15 minute light soak with a 455-nm filter, activating the CdS buffer. Further improvement up to 73% is shown after white-light soak, indicating that ZMO activation is also beneficial.

The devices with optimized ZMO/two layer (Sections b and c) also improved by a few % absolute after the 455-nm soak with no further influence due to white light. Thus, the ZMO is fully optimized and further improvement of bottom cell performance can be accomplished with optimization of the CdS buffer. The CdS thickness reduction can lead to some improvement, as demonstrated in Section c.

While the present invention has been described in conjunction with the specific embodiments outlined above, it is evident that many alternatives, modifications and variations will be apparent to those skilled in the art. Accordingly, the embodiments of the present invention as set forth above are intended to be illustrative, not limiting. Various changes may be made without departing from the spirit and scope of the teachings of the present invention as defined in the following claims and their equivalents.

## Claims

1. A photovoltaic device comprising:
   a bottom cell including:

   a back contact;
   a CIGS absorber layer formulated to absorb photons in light radiation wavelength of about 700 nm or greater, the CIGS absorber layer residing over the back contact;
   a first buffer layer adapted to photovoltaically interact with the CIGS absorber layer, the first buffer layer residing over the CIGS absorber layer, the first buffer layer including:

   a first carrier density; and
   a thickness range of about 5 nm to about 200 nm;
   a second buffer layer residing over the first buffer layer, the second buffer layer including:

   a second carrier density that is at least 100 times greater than the first carrier density;
   a first undoped portion including a thickness of about 30 nm or greater;
   a second doped second portion including a thickness range of up to about 170 nm, the second portion residing over the first portion;
   a window layer residing over the second buffer layer; and
   a top cell residing over the bottom cell formulated to absorb photons in the light radiation wavelength less than about 700nm.

2. The photovoltaic device of claim 1, wherein the back contact is Molybdenum or Molybdenum doped with a group I material and/or wherein the first buffer layer is CdS and/or wherein the second buffer layer includes ZnMgO with the amount of Mg equal to $\frac{Mg}{(Mg+Zn)} = 0.15$ .

3. The photovoltaic device of any one claim 1 or 2, wherein:

   the first undoped portion of the second buffer layer is substantially free of oxygen; and
   the second portion of the second buffer layer is doped with oxygen.

4. The photovoltaic device of any one of the preceding claims, wherein the CIGS absorber layer includes a $\frac{Ga}{(Ga+In}$ range of about 0 to 0.3 and/or wherein the first buffer layer is CdS; and the second buffer layer includes ZnMgO with the amount of Mg equal to $\dfrac{\text{Mg}}{\text{(Mg+Zn)}} = 0.15$.

5. The photovoltaic device of any one of the preceding claims, wherein:

the first buffer layer is CdS; and
the second buffer layer includes:

ZnMgO with the amount of Mg equal to $\dfrac{\text{Mg}}{\text{(Mg+Zn)}} = 0.15$;

the first undoped portion is substantially free of oxygen;
the second portion is doped with oxygen.

6. A photovoltaic device comprising:
a bottom cell including:

a back contact;
a CIGS absorber layer adapted for interacting with a light radiation wavelength of about 380 nm to about 750 nm, and the CIGS absorber layer residing over the back contact;
a first buffer layer adapted for said light radiation wavelength to photovoltaically interact with the CIGS absorber layer, and the first buffer layer residing over the CIGS absorber layer;
the first buffer layer including:

a first carrier density;
a thickness range of about 5 nm to about 200 nm;
a second buffer layer adapted for said light radiation wavelength to interact with the first buffer layer, and the second buffer layer residing over the first buffer layer;
the second buffer layer including:

a second carrier density being at least 100 times greater than the first carrier density;
a first undoped portion including a thickness of about 30 nm or greater, and the first undoped portion is substantially free of oxygen;
a second portion doped with oxygen, and the second portion residing over the first portion;
the second portion including a thickness range of up to about 170 nm;
a window layer adapted for interacting with said light radiation wavelength, and the window layer residing over the second buffer layer; and
a top cell adapted for interacting with said light radiation wavelength, and the top cell residing over the bottom cell.

7. The photovoltaic device of claim 6, wherein the first buffer layer is CdS and/or wherein the second buffer layer includes ZnMgO with the amount of Mg equal to $\dfrac{\text{Mg}}{\text{(Mg+Zn)}} = 0.15$.

8. The photovoltaic device of claim 6 or 7, wherein the CIGS absorber layer includes a $\dfrac{\text{Ga}}{\text{(Ga+In)}}$ range of about 0 to 0.3.

9. A photovoltaic filter comprising:

an absorber layer adapted for interacting with a light radiation wavelength of about 380 nm to about 750 nm;
a photovoltaic filter residing over the absorber layer, the photovoltaic filter including:

a first layer adapted for said radiation wavelength to photovoltaically interact with the absorber layer, and the first layer residing over the absorber layer;
the first filter layer including:

a first carrier density;

a thickness range of about 5 nm to about 200 nm;
a second filter layer adapted for said light radiation wavelength to interact with the first filter layer, and the second filter layer residing over the first filter layer; and
the second filter layer including:

a second carrier density being at least 100 times greater than the first carrier density;
a first undoped portion including a thickness of about 30 nm or greater;
a doped second portion including a thickness range of up to about 170 nm, and the second portion residing over the first portion.

10. The photovoltaic filter of claim 9, wherein the absorber layer is CIGS and/or wherein the CIGS absorber layer includes a $\frac{Ga}{(Ga+In)}$ range of about 0 to 0.3.

11. The photovoltaic filter of claim 10, wherein the first filter layer is CdS and/or wherein the second filter layer includes ZnMgO with the amount of Mg equal to $\frac{Mg}{(Mg+Zn)} = 0.15$ .

12. The photovoltaic filter of any one of claims 9 to 11, wherein:

the first undoped portion of the second filter layer is substantially free of oxygen; and
the second portion of the second filter layer is doped with oxygen.

13. The photovoltaic filter of any one of claims 9 to 12, further comprising:

a back contact residing under the absorber layer;
a window layer adapted for interacting with said light radiation wavelength, and the window layer residing over the photovoltaic filter; and
a top cell adapted for interacting with said light radiation wavelength, and the top cell residing over the window layer.

14. The photovoltaic filter of any one of claim 9 to 13, wherein the back contact is Molybdenum or Molybdenum doped with a group I material.

# Figure 1

Light 1140        Light 1140

|  |
|---|
| Top cell 1010 |
| Window layer 1120 |
| Second buffer layer 1100 |
| First buffer layer 1080 |
| Absorber layer 1060 |
| Back contact 1040 |

Bottom cell 1020

# Figure 2a

# Figure 2b

# Figure 2c

# Figure 2d and 2e

# Figures 3a and 3b

# Figure 4

# Figure 5a and 5b

# Figures 6a and 6 b

# Figures 7a and 7b

# Figure 7c

# Figure 8

# Figure 9

1100

910

920

1080

| Europäisches Patentamt / European Patent Office / Office européen des brevets | **EUROPEAN SEARCH REPORT** | Application Number |
|---|---|---|
| | | EP 25 20 3355 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SINGH YASHWANT KUMAR ET AL: "Current matching and filtered spectrum analysis of wide-bandgap/narrow-bandgap perovskite/CIGS tandem solar cells: A numerical study of 34.52 % efficiency potential", JOURNAL OF PHYSICS AND CHEMISTRY OF SOLIDS, PERGAMON PRESS, LONDON, GB, vol. 196, 5 September 2024 (2024-09-05), XP087646764, ISSN: 0022-3697, DOI: 10.1016/J.JPCS.2024.112300 [retrieved on 2024-09-05] | 1-3,6, 8-14 | INV. H10F10/161 H10F10/167 |
| A | * figure 1(c); table 1 * | 4,5,7 | |
| X | HO SONG SANG ET AL: "Metal-oxide broken-gap tunnel junction for copper indium gallium diselenide tandem solar cells", SOLAR ENERGY MATERIALS AND SOLAR CELLS, vol. 133, 1 February 2015 (2015-02-01), pages 133-142, XP055868330, NL ISSN: 0927-0248, DOI: 10.1016/j.solmat.2014.10.046 | 1-3,6, 8-14 | |
| A | * figure 8(a) * | 4,5,7 | TECHNICAL FIELDS SEARCHED (IPC)<br><br>H10F |
| A | CN 209 607 754 U (YANCHUANG APPLIED MAT GANZHOU INC LTD) 8 November 2019 (2019-11-08) * figure 1 * | 1-14 | |
| A | CN 102 931 248 A (UNIV JIAOTONG SOUTHWEST) 13 February 2013 (2013-02-13) * claim 2; figure 1 * | 1-14 | |

-/--

The present search report has been drawn up for all claims

| Place of search | Date of completion of the search | Examiner |
|---|---|---|
| Berlin | 26 January 2026 | Le Meur, M |

Europäisches
Patentamt

European
Patent Office

Office européen
des brevets

## EUROPEAN SEARCH REPORT

**Application Number**

EP 25 20 3355

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PUDOV A ET AL: "Secondary barriers in CdS-CuIn1-xGaxSe2 solar cells", JOURNAL OF APPLIED PHYSICS, AMERICAN INSTITUTE OF PHYSICS, 2 HUNTINGTON QUADRANGLE, MELVILLE, NY 11747, vol. 97, no. 6, 1 March 2005 (2005-03-01), pages 64901-064901, XP012070899, ISSN: 0021-8979, DOI: 10.1063/1.1850604 * the whole document * ----- | 1-14 | |
| A | XIAONAN LI ET AL: "Impact of Zn1-XMnXO on Cu(In,Ga)Se2 thin-film solar cells", PHOTOVOLTAIC SPECIALISTS CONFERENCE (PVSC), 2009 34TH IEEE, IEEE, PISCATAWAY, NJ, USA, 7 June 2009 (2009-06-07), pages 305-308, XP031626873, ISBN: 978-1-4244-2949-3 * the whole document * ----- | 1-14 | |

**TECHNICAL FIELDS
SEARCHED      (IPC)**

The present search report has been drawn up for all claims

| Place of search | Date of completion of the search | Examiner |
|---|---|---|
| Berlin | 26 January 2026 | Le Meur, M |

EPO FORM 1503 03.82 (P04C01)

## ANNEX TO THE EUROPEAN SEARCH REPORT
## ON EUROPEAN PATENT APPLICATION NO.

EP 25 20 3355

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2026

| Patent document cited in search report | | Publication date | Patent family member(s) | Publication date |
|---|---|---|---|---|
| CN 209607754 | U | 08-11-2019 | NONE | |
| CN 102931248 | A | 13-02-2013 | NONE | |

For more details about this annex : see Official Journal of the European Patent Office, No. 12/82

EPO FORM P0459